Europäisches Patentamt

European Patent Office

Office européen des brevets

(19)

(11) Veröffentlichungsnummer : **0 096 294**
**B1**

(12) **EUROPÄISCHE PATENTSCHRIFT**

(45) Veröffentlichungstag der Patentschrift :
15.03.89

(51) Int. Cl.⁴ : **G 03 F 7/20**

(21) Anmeldenummer : **83105150.3**

(22) Anmeldetag : **25.05.83**

(54) Positionierungsvorrichtung.

(30) Priorität : **03.06.82 DE 3220861**

(43) Veröffentlichungstag der Anmeldung :
**21.12.83 Patentblatt 83/51**

(45) Bekanntmachung des Hinweises auf die Patenterteilung : **15.03.89 Patentblatt 89/11**

(84) Benannte Vertragsstaaten :
**BE DE FR GB IT NL**

(56) Entgegenhaltungen :
**JP--A--57 078 541**
**US--A-- 2 565 054**
**PATENTS ABSTRACTS OF JAPAN, Band 6, Nr. 159 (P-
136)[1037], 20. August 1982; & JP-A- 57 78541**

(73) Patentinhaber : **HOECHST AKTIENGESELLSCHAFT**
**Postfach 80 03 20**
**D-6230 Frankfurt am Main 80 (DE)**

(72) Erfinder : **Back, Günter**
**Rosenstrasse 33**
**D-6238 Hofheim 3 (DE)**

## Beschreibung

Die Erfindung betrifft eine Positionierungsvor-richtung in einem Belichtungs-/Entwicklungsge-rät für Druckformen, die mittels einer Rollentransportvorrichtung auf einen Belichtungstisch transportiert werden, mit einer Einrichtung aus Druckstück und zumindest einem Anschlagstift für die Seitenpositionierung und einer Einrichtung aus Druckstück und Anschlag für die Längspositionierung der einzelnen Druckform.

Die Herstellung von beschrifteten und bebilderten Druckformen, beispielsweise Druckplatten, die unmittelbar nach erfolgter Belichtung und Entwicklung zum Drucken geeignet sind, geschieht in der Weise, daß die Druckplatten zuerst elektrostatisch aufgeladen und anschließend eine Vorlage bildmäßig auf die einzelne Druckplatte projiziert wird. Nach Beendigung dieses Belichtungsvorgangs wird die Druckplatte mit einem Entwickler entwickelt, fixiert und entschichtet, wonach sie fertig für den Druckvorgang ist.

Aus der Zusammenfassung in dem Dokument « Patents Abstracts of Japan », Band 6, Nr. 159 (P 136) (1037), 20. August 1982 und der japanischen Offenlegungsschrift JP-A 870,541/82 der Anmelderin Fuji Shashin Film K. K., offengelegt am 17.5.1982, ist eine Positionierungsvorrichtung der eingangs beschriebenen Art bekannt, bei der eine Führungsplatte den Vorderteil einer Druckplatte hält und führt. Sobald die Vorderkante der Platte an einem Positionierstift anliegt, wird die Platte in einer Position angehalten, in der ein Druckteil mittels einer Feder gegen die Hinterkante der Platte drückt. Ein weiteres Druckteil für die Seitenpositionierung drückt gegen eine Seitenkante der Platte und bringt diese zum Anliegen an einen seitlichen Positionierstift. Nach dem Positionieren wird die Druckplatte durch eine Saugeinrichtung in eine Druckstellung positioniert, wobei der Positionierstift von der Vorderkante der Platte weggeschwenkt und aus der Transportbahn der Platte zurückgestellt wird.

Die Positionierung der Platte erfolgt bei dieser Vorrichtung mechanisch über Federkraft, eine Anpassung an unterschiedliche Formatgrößen der Platten ist nicht möglich.

Aus der DE-OS 30 12 761 ist eine Vorrichtung für den Einzug und den Transport von Druckplatten auf einen Belichtungstisch mit Hilfe von Transportrollen bekannt. Die oberste der in einem Magazin gestapelten Druckplatten wird bei dieser Vorrichtung von einem schwenkbaren Hubzylinder erfaßt und kreisbogenförmig auf eine Saugplatte des Belichtungstisches aufgesetzt. Zu beiden Seiten der Saugplatte sind die Transportrollen angeordnet, die von je einer Antriebsrolle in jeder Reihe über Rundschnurtransportringe angetrieben werden. Die in Transportrichtung der Druckplatte zuerst liegenden Transportrollen jeder Reihe sind auf Schwenkblöcken angeordnet, die vor dem Aufsetzen der Druckplatte nach außen aus den Reihen geschwenkt werden, um ein klemmfreies Ablegen des Vorderteils der Druckplatte auf die Saugplatte zu ermöglichen. Sobald die Druckplatte auf der Saugplatte aufliegt, werden die vorderen Transportrollen an die Seitenkante der Druckplatte angeschwenkt und diese vorwärts transportiert, wobei die Seitenkanten in Rillen der Transportrollen geführt sind. Die Druckplatte wird solange auf der Saugplatte vorwärtstransportiert, bis sie gegen einen Anschlagstift anliegt. Sobald die Druckplatte durch den Anschlagstift positioniert ist, wird die Saugplatte mit Unterdruck beaufschlagt, wodurch die Druckplatte in ihrer Belichtungslage festgehalten wird. Danach erfolgt die Aufladung der Druckplatte durch eine Korona und anschließend die Belichtung. Nach Beendigung der Belichtung wird der Anschlagstift versenkt, so daß die Druckplatte durch die Transportrollen auf einen Entwicklungstisch weitertransportiert werden kann.

Bei dieser Vorrichtung erfolgt die Positionierung der Druckplatte nur in Transportrichtung, d. h. in ihrer Längsrichtung, nicht jedoch seitlich dazu.

In der deutschen Patentanmeldung P 31 22 321.4 wird eine Vorrichtung für den Einzug und den Transport von Druckplatten auf einen Belichtungstisch mit Hilfe von paarweise angeordneten Rollen vorgeschlagen, die auf zwei Rollenleisten mittels Blöcken befestigt sind. Die Rollenleisten sind zu beiden Seiten des Belichtungstisches in Transportrichtung angeordnet und die in Transportrichtung zuerst liegenden Transportrollen sind auf Schwenkblöcken montiert, die vor dem Aufsetzen der Druckplatte nach außen geschwenkt werden und nach dem Aufsetzen der Druckplatte wieder angeschwenkt werden, um zusammen mit den übrigen Rollen den Plattentransport zu übernehmen. Die Druckplatte wird solange auf der Saugplatte vorwärtstransportiert, bis sie gegen einen Anschlag anliegt, der in die Saugplatte versenkbar ist. Nachdem die Druckplatte durch den Anschlag positioniert ist, wird sie mit Unterdruck beaufschlagt, so daß sie in ihrer Belichtungslage festgehalten wird. Auch bei dieser vorgeschlagenen Vorrichtung erfolgt die Positionierung mittels eines Anschlags nur in Transportrichtung der Druckplatte, d. h. in ihrer Längsrichtung, nicht jedoch seitlich dazu. In der Belichtungslage werden die Rollenleisten in ihrer Gesamtheit parallel zu sich selbst von dem Belichtungstisch weggeschwenkt, so daß die Druckplatte bis zu ihren Außenkanten ungehindert belichtet werden kann.

Bei den bekannten Geräten wird die Druckform nur in Längsrichtung durch Anlegen der Vorderkante der Druckform an einem Anschlag positioniert, ohne daß die Hinterkante der Druckform ausgerichtet wird bzw. auf die Hinterkante ein bestimmter Anpreßdruck in Richtung Anschlag ausgeübt wird. Eine seitliche Positionierung bzw. Ausrichtung erfolgt nicht, sondern nur eine Führung der Druckform durch Transportrollen, in deren Rillen sich die beiden Längskanten der Druckform bewegen. Es ist daher eine präzise und reproduzierbare Ausrichtung der Druckform auf dem Belichtungstisch bei den bekannten Geräten nur im beschränkten Umfang möglich.

Aufgabe der Erfindung ist es, die Positionierungsvorrichtung schnell und mit geringem Arbeitsaufwand auf unterschiedliche Formatgrößen der einzelnen Druckformen einzustellen und die Druckformen in Längs- und Seitenrichtung in reproduzierbarer Weise mit großer Genauigkeit ausrichten zu können.

Diese Aufgabe wird erfindungsgemäß von einer Positionierungsvorrichtung der eingangs beschriebenen Art dadurch gelöst, daß das pneumatisch betätigte Druckstück für die Seitenpositionierung aus einem zylindrischen hohlen Bolzen und einem Ring auf einer Kolbenstange eines mit Druckluft beaufschlagbaren Hubzylinders gelagert ist, der in einer auf einer Montageplatte befestigten Halterung einstellbar ist, daß die dem Druckstück gegenüberliegenden Anschlagstifte auf dem Belichtungstisch justierbar sind und daß das Druckstück für die Längspositionierung ein gleichzeitig mit dem Druckstück für die Seitenpositionierung pneumatisch betätigter Schieber ist.

In Ausgestaltung der Erfindung ist das Druckstück durch einen Stift, der in einem Schlitz des Bolzens geführt ist und die Kolbenstange durchsetzt, auf dieser befestigt.

In Weiterbildung der Erfindung ist im Inneren des Bolzens eine Druckfeder angeordnet, die das Druckstück in der Ruhelage der Kolbenstange gegen den Stift drückt.

Der Hubzylinder ist in vorteilhafter Weise über ein Magnetventil mit einer Druckleitung verbunden, die bei erregtem Magnetventil den Hubzylinder mit Druckluft beaufschlägt, welche die Kolbenstange in Richtung Druckform ausfährt. Zum Abbau der Druckluft ist das Magnetventil mit einem Drosselschalldämpfer verbunden, durch den bei entregtem Magnetventil die Druckluft austritt.

In weiterer Ausgestaltung der Erfindung ist auf der Montageplatte eine justierbare Einstellschiene montiert, auf der ein Mikroschalter angeordnet ist, dessen Schaltfahne in die Bewegungsbahn des Ringes des Druckstückes hineinragt. Sobald der Mikroschalter betätigt wird, erregt er ein Magnetventil, das einen mit dem Belichtungssaugtisch verbundenen Vakuumsaugkopf mit Druckluft beaufschlägt, um die Druckplatte anzusaugen.

Die Einrichtung zur Längspositionierung der Druckplatte ist derart ausgebildet, daß der Schieber in einer Langlochführung des Belichtungssaugtisches geführt und um einen Bolzen auf einem Druckstück schwenkbar gelagert ist. Zweckmäßigerweise ist auf der Unterseite des Belichtungssaugtisches eine Lagerung angeordnet, in der ein Hubzylinder verstellbar ist, auf dessen Kolbenstange das Druckstück aufsitzt, in dessen Innerem sich eine Druckfeder befindet. Die Kolbenstange ist vorteilhafterweise mit einem Bolzen ausgerüstet, der in einem Langloch des Druckstückes geführt ist, und die Stirnfläche der Kolbenstange liegt gegen die Druckfeder an.

Die weitere vorteilhafte Ausgestaltung der Erfindung ergibt sich aus den Patentansprüchen 11 bis 17.

Mit der Erfindung wird der Vorteil erzielt, daß die Druckform sowohl in Längs- als auch in Seitenrichtung mit gleichmäßigem Druck gegen Anschläge, mit großer Genauigkeit ausgerichtet, anliegt, wobei der Druck derart dosiert wird, daß keine Beschädigungen der Kanten der Druckform auftreten.

Die Erfindung wird im folgenden anhand eines zeichnerisch dargestellten Ausführungsbeispiels näher erläutert.

Es zeigen :

Fig. 1 eine Draufsicht auf die Positionierungsvorrichtung mit den Einrichtungen für die Seiten- und Längspositionierung einer Druckform,

Fig. 2 die Einrichtung zur Seitenpositionierung der Druckform schematisch im Schnitt,

Fig. 3 die Einrichtung zur Längspositionierung der Druckform, schematisch im Schnitt, und

Fig. 4 in perspektivischer Ansicht den Schieber und die Schenkelfeder nach Fig. 3.

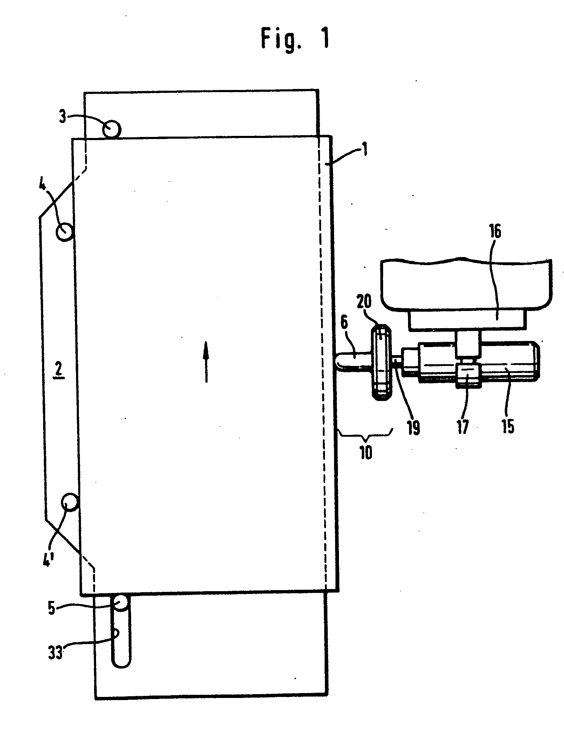

Die in Fig. 1 schematisch dargestellte Positionierungsvorrichtung besteht aus einer Einrichtung zur Seitenpositionierung und einer Einrichtung zur Längspositionierung einer Druckform 1, beispielsweise einer Druckplatte, die mit Hilfe einer nicht dargestellten Rollentransportvorrichtung auf einen Belichtungstisch 2 transportiert wird. Die Einrichtung für die Seitenpositionierung der Druckform 1 umfaßt ein Druckstück 10 mit einem Bolzen 6 sowie Anschlagstifte 4, 4', die dem Druckstück 10, getrennt durch die Breite der Druckform 1, gegenüberliegen. Bei dem Belichtungstisch 2 handelt es sich um einen Belichtungssaugtisch, der mit Unterdruck beaufschlagt wird, sobald die Druckform 1 sowohl in Längs- als auch in Seitenrichtung positioniert ist. Das Druckstück 10 schiebt mittels des Bolzens 6 die Druckform 1 gegen die beiden Anschlagstifte 4, 4', die auf dem Belichtungssaugtisch 2 justierbar montiert sind.

Die Einrichtung für die Längspositionierung der Druckform 1, das ist die Ausrichtung in Transportrichtung der Druckplatte, besteht aus einem Schieber 5, der in einer Langlochführung 33 verschiebbar ist und aus einem Anschlag 3 für die Vorderkante der Druckplatte. Der Schieber 5 ist zunächst nach unten geschwenkt, so daß ihn die Druckplatte ohne Behinderung überfahren kann. Sobald die Druckplatte zur Gänze den Schieber 5 passiert hat, schwenkt dieser nach oben, liegt an der Hinterkante der Druckplatte an und schiebt diese gegen den Anschlag 3.

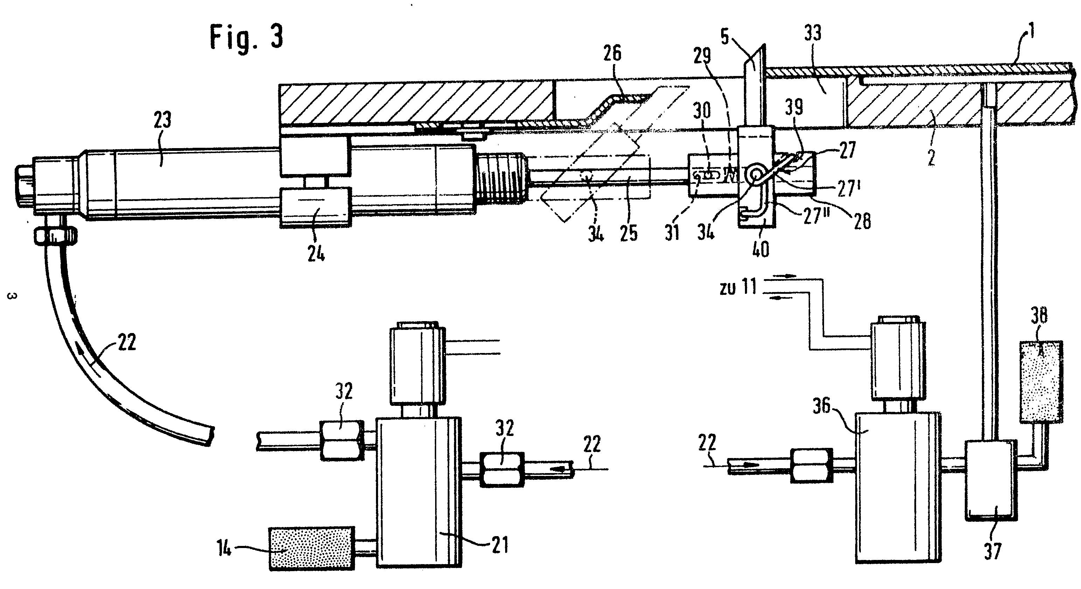

Die Einrichtung zur Seitenpositionierung betätigt in Positionslage einen Schalter, der über ein Magnetventil mittels eines Vakuumssaugkopfes die Druckplatte an die Oberfläche des Belichtungssaugtisches 2 ansaugt, wie dies noch im einzelnen anhand von Fig. 3 beschrieben werden wird.

Der Anschlag 3 für die Vorderkante der Druckplatte ist versenkbar ausgebildet. Sobald die Druckplatte an die Oberfläche des Belichtungssaugtisches 2 angesaugt ist, gehen der Anschlag 3, der Schieber 5 und das Druckstück 10 mit dem Bolzen 6 in ihre jeweilige Ausgangslage zurück und die Druckplatte ist somit zur Belichtung positioniert.

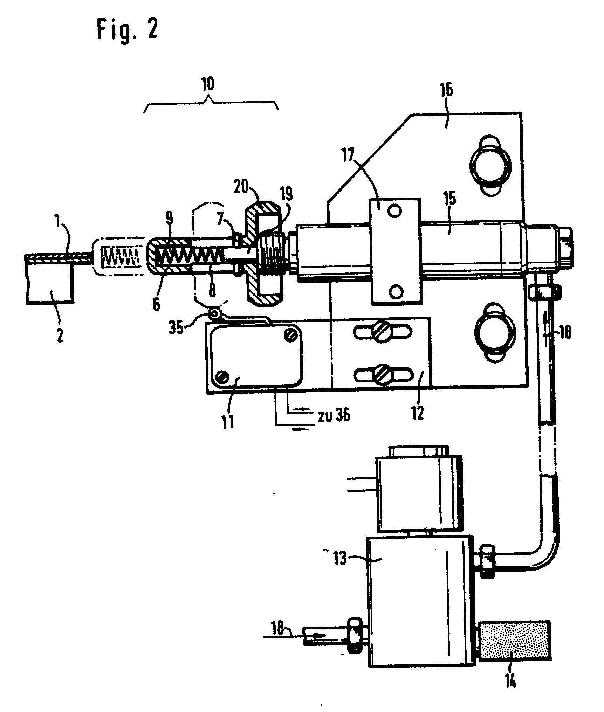

Einzelheiten der Einrichtung zur Seitenpositionierung der Druckplatte werden im folgenden anhand von Fig. 2 näher beschrieben.

Die auf den Belichtungssaugtisch 2 aufgelegte und mit Hilfe von nicht gezeigten Transportrollen in eine positionsnahe Lage beförderte Druckplatte 1 wird durch den Bolzen 6 des Druckstückes 10 an die zwei in Fig. 1 dargestellten Anschlagstifte 4 und 4' an der Gegenseite geschoben. Das Druckstück 10 besteht aus dem zylindrischen hohlen Bolzen 6 und einem Ring 20 und ist auf einer Kolbenstange 19 eines Hubzylinders 15 gelagert. Die Befestigung des Druckstückes 10 auf der Kolbenstange 19 erfolgt durch einen Stift 7, der in einem Schlitz 8 geführt ist. Eine Druckfeder 9 im Inneren des Bolzens 6 hält das Druckstück 10 in Ruhelage gegen den Stift 7 gedrückt.

Der Hubzylinder 15 ist in einer Halterung 17 einstellbar, die auf einer Montageplatte 16 befestigt ist. Je nach der Breite der zu verarbeitenden Druckplatten wird der Hubzylinder 15 in der Halterung 17 verschoben. Der Hubzylinder 15 ist über ein Magnetventil 13 mit einer Druckleitung verbunden, die bei erregtem Magnetventil den Hubzylinder 15 mit Druckluft 18 beaufschlägt. Die in den Hubzylinder 15 einströmende Druckluft fährt die Kolbenstange 19 auf die volle Hublänge aus. Beim Ausfahren wird das Druckstück 10 mitgenommen und die Vorderkante des Bolzens trifft auf die Längskante der Druckplatte 1 auf. Die Druckplatte wird nun bis zu den gegenüberliegenden festen Anschlagstiften 4, 4' seitlich verschoben. Innerhalb des Druckstückes 10 fährt die Kolbenstange 19 auf die volle Hublänge weiter und drückt die Druckfeder 9 zusammen, wobei der Stift 7 in dem Schlitz 8 in Richtung Druckplatte verfahren wird. Die Druckplatte wird lediglich von der Feder 9 über den Bolzen 6 des Druckstückes 10 gegen die beiden festen Anschlagstifte 4, 4' gedrückt, wobei die Feder 9 die auf die volle Hublänge ausgefahrene Kolbenstange 19 soweit abfedert, daß die Anlage des Bolzens 6 an die Längskante der Druckplatte 1 elastisch und nicht starr erfolgt. Dadurch ist sichergestellt, daß durch die auf die volle Hublänge ausgefahrene Kolbenstange 19 die Druckplattenkante nicht beschädigt wird.

Das Magnetventil 13 ist mit einem Drosselschalldämpfer 14 ausgerüstet, durch den bei entregtem Magnetventil 13 die Druckluft 18 ohne große Geräuschentwicklung austreten kann und über den die Kolbenbewegung regelbar ist. Sobald das Magnetventil 36 entregt wird, wird der Unterdruck auf den Belichtungssaugtisch 2 aufgehoben, so daß die Druckplatte 1 von dem Belichtungssaugtisch 2 abtransportiert werden kann.

Die Längspositionierung, die noch nachstehend anhand der Fig. 2 und 3 beschrieben werden wird, beginnt gleichzeitig mit der Seitenpositionierung.

Auf der Montageplatte 16 ist eine justierbare Einstellschiene 12 montiert, auf der ein Mikroschalter 11 angebracht ist, dessen Schaltfahne 35 in die Bewegungsbahn des Ringes 20 hineinragt.

Sobald das Druckstück 10 die in Fig. 2 fest eingezeichnete Position verlassen hat und die gestrichelte Position in Fig. 2 einnimmt, in welcher der Bolzen 6 an der Längskante der Druckplatte 1 anliegt, betätigt der Ring 20 die Schaltfahne 35 des Mikroschalters 11. Der Mikroschalter 11 erregt ein weiteres Magnetventil 36, das in Fig. 3 gezeigt ist. Sobald das Magnetventil 36 erregt ist, wird ein Vakuumsaugkopf 37, der mit dem Belichtungssaugtisch 2 verbunden ist, mit Druckluft 22 beaufschlägt. Im Vakuumsaugkopf 37 entsteht dabei Unterdruck bzw. Saugluft, wodurch die Druckplatte 1 an die Oberfläche des Belichtungssaugtisches 2 angesaugt wird.

Sobald die Druckplatte 1 angesaugt ist, schaltet ein nicht dargestellter Vakuumschalter bei fortbestehendem Vakuum das Magnetventil 13 aus, so daß die Druckluft 18 durch den Drosselschalldämpfer 14 des Magnetventils 13 austreten kann. Somit ist der Hubzylinder 15 nicht länger mit Druckluft beaufschlägt, so daß eine nicht gezeigte Rückholfeder im Hubzylinder die Kolbenstange 19 und mit ihr das Druckstück 10 in die Ausgangslage zurückziehen kann. Es liegt sodann die Druckplatte 1 angesaugt und zur Belichtung fertig positioniert auf dem Belichtungssaugtisch 2.

Anhand von Fig. 3 wird im folgenden die Einrichtung zur Längspositionierung der Druckplatte 1 näher beschrieben. Der Schieber 5 ist in der Langlochführung 33 des Belichtungssaugtisches 2 geführt und um einen Bolzen 34 auf einem Druckstück 28 schwenkbar gelagert. Die Druckplatte 1 läuft beim Transport auf dem Belichtungssaugtisch 2 über den in Schräglage gekippten Schieber 5 der Einrichtung für die Längspositionierung.

Auf der Unterseite des Belichtungssaugtisches 2 ist eine Lagerung 24 angeordnet, in der ein Hubzylinder 23, der dem Hubzylinder 15 für die Seitenpositionierung gleicht, verstellbar ist. Auf der Kolbenstange 25 des Hubzylinders 23 sitzt das Druckstück 28 auf, in dessen Innerem sich eine Druckfeder 29 befindet. Gleichzeitig mit der Seitenpositionierung wird ein Magnetventil 21 erregt und die Kolbenstange 25 mittels Druckluft 22 nach rechts gedrückt.

Auf der Unterseite des Belichtungssaugtisches 2 ist ein Anschlagblech 26 angeordnet, das in die Langlochführung 33 des Belichtungssaugtisches 2 hineinragt. Das Anschlagblech 26 ist gewinkelt und beim Einfahren der Kolbenstange 25 des Hubzylinders 23, d. h. beim Verfahren in Fig. 3 nach links, wird der Schieber 5 gegen das Anschlagblech 26 gedrückt und um den Bolzen 34 schräg nach unten geschwenkt. Die Stirnfläche des Schiebers 5 ist abgeschrägt und liegt im geschwenkten Zustand des Schiebers 1 bis 2 mm unterhalb der Oberfläche des Belichtungssaugtisches 2.

Bei einer Bewegung der Kolbenstange 25 nach rechts wird der Schieber 5 von dem Anschlagblech 26 gelöst und von einer Schenkelfeder 27 aufgerichtet, die auf dem Druckstück 28 angeordnet ist. Der Schieber 5 drückt dann die Druckplatte 1 mit ihrer Vorderkante gegen den in Fig. 1 dargestellten Anschlag 3. Sobald die Druckplatte 1 den Anschlag 3 trifft, übt sie einen leichten gleichmäßigen Druck auf den Schieber 5 aus, der in seiner Lage stehenbleibt. Die noch um einige Millimeter weiterfahrende Kolbenstange 25 drückt die im Druckstück 28 befindliche Druckfeder 29 zusammen.

Die Kolbenstange 25 ist mit einem Bolzen 30 ausgerüstet, der in einem Langloch 31 des Druckstückes 28 geführt ist. Mit der Stirnfläche liegt die Kolbenstange 25 gegen die Druckfeder 29 an, die somit die mit voller Kraft auf ihre Endlänge ausfahrende Kolbenstange 25 abfedert. Dadurch wird die zwischen dem Anschlag 3 und dem Schieber 5 positionierte Druckplatte 1 durch die Druckfeder 29 gegen eine Beschädigung durch die Kolbenstange 25 geschützt. Das Ansaugen der Druckplatte 1 in dieser Lage wird durch die Seitenpositionierung ausgelöst, wie dies voranstehend anhand von Fig. 2 beschrieben wurde.

In der Luftzuleitung oder -ableitung des Magnetventils 21 ist eine Luftdrossel 32 angeordnet, über welche die Geschwindigkeit der Kolbenstangenbewegung regelbar ist. An das Magnetventil 21 ist ein Drosselschalldämpfer 14 angeschlossen, durch den bei entregtem Magnetventil 21 Druckluft 22 regelbar austritt. Das Magnetventil 21 wird entregt, sobald das entsprechende Vakuum im Belichtungssaugtisch erreicht ist.

Eine im Hubzylinder 23 befindliche, nicht dargestellte Druckfeder drückt die Kolbenstange 25 in den Hubzylinder zurück. Wie schon zuvor erwähnt wurde, gleitet der Schieber 5 in der Langlochführung 33 nach links, bis er von dem Anschlagblech 26 in die Schräglage gedrückt wird. Nach der Belichtung der Druckplatte kann eine neue Druckplatte über den Schieber 5 transportiert und neu positioniert werden.

Zur Erzeugung eines Unterdrucks im Belichtungssaugtisch 2 ist dieser über den Vakuumsaugkopf 37 mit dem Magnetventil 36 verbunden, das im erregten Zustand mit Druckluft 22 beaufschlagt wird. Mit dem Vakuumsaugkopf 37 steht ein Schalldämpfer 38 in Verbindung, über den Druckluft 22 ausströmt, die im Betrieb des Vakuumsaugkopfes, der nach dem Prinzip eines Venturirohrs arbeitet, Unterdruck erzeugt.

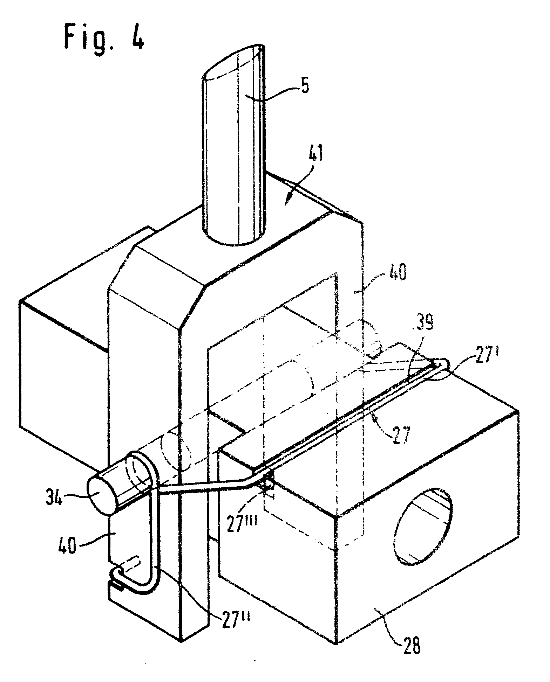

Fig. 4 zeigt eine perspektivische Ansicht des Druckstücks 28 und des Schiebers 5. Die dreiteilige Schenkelfeder 27 greift mit den einen Schenkel 27' in eine Rille 39 auf der Oberseite des Druckstückes 28 ein. Die beiden anderen Schenkel 27'' und 27''' der Schenkelfeder 27 umfassen Schenkel 40 eines Gabelstücks 41, wobei die Enden dieser beiden Schenkel in Nuten nahe den Schenkelenden eingreifen. Der Schenkel 27' einerseits und die beiden Schenkel 27'' und 27''' andererseits streben unter dem Einfluß ihrer Federspannung im unbelasteten Zustand voneinander weg. Das Gabelstück 41 umschließt mit Spiel gegenüber der Oberfläche des Druckstückes 28 dessen schmaleren Abschnitt und wird von dem Bolzen 34 durchsetzt.

## Patentansprüche

1. Positionierungsvorrichtung in einem Belichtungs-/Entwicklungsgerät für Druckformen, die mittels einer Rollentransportvorrichtung auf einen Belichtungstisch transportiert werden, mit einer Einrichtung aus Druckstück und zumindest einem Anschlagstift für die Seitenpositionierung und einer Einrichtung aus Druckstück und Anschlag für die Längspositionierung der einzelnen Druckform, dadurch gekennzeichnet, daß das pneumatisch betätigte Druckstück (10) für die Seitenpositionierung aus einem zylindrischen hohlen Bolzen (6) und einem Ring (20) auf einer Kolbenstange (19) eines mit Druckluft beaufschlagbaren Hubzylinders (15) gelagert ist, der in einer auf einer Montageplatte (16) befestigten Halterung (17) einstellbar ist, daß die dem Druckstück (10) gegenüberliegenden Anschlagstifte (4, 4') auf dem Belichtungstisch (2) justierbar sind und daß das Druckstück für die Längspositionierung ein gleichzeitig mit dem Druckstück (10) für die Seitenpositionierung pneumatisch betätigter Schieber (5) ist.

2. Positionierungsvorrichtung nach Anspruch 1, dadurch gekennzeichnet, daß das Druckstück (10) durch einen Stift (7), der in einem Schlitz (8) des Bolzens (6) geführt ist und die Kolbenstange (19) durchsetzt, auf dieser befestigt ist.

3. Positionierungsvorrichtung nach Anspruch 1, dadurch gekennzeichnet, daß im Inneren des Bolzens (6) eine Druckfeder (9) angeordnet ist, die das Druckstück (10) in der Ruhelage der Kolbenstange (19) gegen den Stift (7) drückt.

4. Positionierungsvorrichtung nach Anspruch 1, dadurch gekennzeichnet, daß der Hubzylinder (15) über ein Magnetventil (13) mit einer Druckleitung verbunden ist, die bei erregtem Magnetventil den Hubzylinder (15) mit Druckluft (18) beaufschlägt, welche die Kolbenstange (19) in Richtung Druckform (1) ausfährt.

5. Positionierungsvorrichtung nach Anspruch 4, dadurch gekennzeichnet, daß das Magnetventil (13) mit einem Drosselschalldämpfer (14) verbunden ist, durch den bei entregtem Magnetventil (13) die Druckluft (18) regelbar austritt.

6. Positionierungsvorrichtung nach Anspruch 1, dadurch gekennzeichnet, daß auf der Montageplatte (16) eine justierbare Einstellschiene (12) montiert ist, auf der ein Mikroschalter (11) angeordnet ist, dessen Schaltfahne (35) in die Bewegungsbahn des Ringes (20) des Druckstückes (10) hineinragt.

7. Positionierungsvorrichtung nach Anspruch 6, dadurch gekennzeichnet, daß der Mikroschalter (11) ein Magnetventil (36) erregt, das einen mit dem Belichtungssaugtisch (2) verbundenen Vakuumsaugkopf (37) mit Druckluft beaufschlagt, um die Druckplatte (1) anzusaugen.

8. Positionierungsvorrichtung nach Anspruch 1, dadurch gekennzeichnet, daß der Schieber (5) in einer Langlochführung (33) des Belichtungssaugtisches (2) geführt und um einen Bolzen (34) auf einem Druckstück (28) schwenkbar gelagert ist.

9. Positionierungsvorrichtung nach Anspruch 8, dadurch gekennzeichnet, daß auf der Unterseite des Belichtungssaugtisches (2) eine Lagerung (24) angeordnet ist, in der ein Hubzylinder (23) verstellbar ist, auf dessen Kolbenstange (25) das Druckstück (28) aufsitzt, in dessen Inneren sich eine Druckfeder (29) befindet.

10. Positionierungsvorrichtung nach Anspruch 9, dadurch gekennzeichnet, daß die Kolbenstange (25) mit einem Bolzen (30) ausgerüstet ist, der in einem Langloch (31) des Druckstückes (28) geführt ist, und daß die Stirnfläche der Kolbenstange (25) gegen die Druckfeder (29) anliegt.

11. Positionierungsvorrichtung nach Anspruch 9, dadurch gekennzeichnet, daß der Hubzylinder (23) mit einem Magnetventil (21) verbunden ist, in dessen Luftzuleitung oder -ableitung eine Luftdrossel (32) angeordnet ist, über welche die Geschwindigkeit der Kolbenstangenbewegung regelbar ist.

12. Positionierungsvorrichtung nach Anspruch 11, dadurch gekennzeichnet, daß an das Magnetventil (21) ein Drosselschalldämpfer (14) angeschlossen ist, durch den bei entregtem Magnetventil (21) Druckluft (22) regelbar austritt.

13. Positionierungsvorrichtung nach Anspruch 9, dadurch gekennzeichnet, daß auf der Unterseite des Belichtungssaugtisches (2) ein Anschlagblech (26) angeordnet ist, das in die Langlochführung (33) des Belichtungssaugtisches (2) hineinragt.

14. Positionierungsvorrichtung nach Anspruch 13, dadurch gekennzeichnet, daß das Anschlagblech (26) gewinkelt ist und beim Einfahren der Kolbenstange (25) des Hubzylinders (23) den Schieber (5) um den Bolzen (34) schräg nach unten schwenkt.

15. Positionierungsvorrichtung nach Anspruch 14, dadurch gekennzeichnet, daß die Stirnfläche des Schiebers (5) abgeschrägt ist und im geschwenkten Zustand des Schiebers (5) 1 bis 2 mm unterhalb der Oberfläche des Belichtungssaugtisches (2) liegt.

16. Positionierungsvorrichtung nach Anspruch 14, dadurch gekennzeichnet, daß eine Schenkelfeder (27) auf dem Druckstück (28) so angeordnet ist und an dem Schieber (5) angreift, daß sie diesen aufrichtet, sobald er von dem Anschlagblech (26) getrennt wird.

17. Positionierungsvorrichtung nach Anspruch 16, dadurch gekennzeichnet, daß die Schenkelfeder (27) dreischenklig ausgebildet ist, wobei ein Schenkel (27') in eine Rille (39) auf der Oberseite des Druckstückes (28) eingreift und die beiden anderen Schenkel (27'', 27''') Schenkel (40) eines Gabelstückes (41) umfassen und in Nuten nahe den Schenkelenden eingreifen.

**Claims**

1. Positioning device in an exposing/developing apparatus for printing forms which are transported onto an exposure table by means of a roller transport device, said positioning device comprising a mechanism including a pressure member and at least one stop pin for positioning the individual printing forms in the transverse direction and a mechanism including a pressure member and a stop for positioning the individual printing forms in the longitudinal direction, characterized in that the pneumatically operated pressure member (10) for the transverse positioning, comprising a cylindrical hollow pin (6) and a ring (20), is supported on a piston rod (19) of a lifting cylinder (15) which is supplied with compressed air and is adjustably accomodated in a support (17) fastened to a mounting plate (16) ; that the stop pins (4, 4') provided opposite the pressure member (10) can be adjusted on the exposure table (2) ; and that the pressure member for the positioning in the longitudinal direction is a pneumatically operated slide member (5) which is activated simultaneously with the pressure member (10) for the positioning in the transverse direction.

2. Positioning device as claimed in claim 1, characterized in that the pressure member (10) is fastened to the piston rod (19) by means of a pin (7) being guided in a slot (8) provided in the pin (6) and penetrating the piston rod (10).

3. Positioning device as claimed in Claim 1, characterized in that a compression spring (9) is arranged in the interior of the pin (6), by which spring (9) the pressure member (10) is pressed against the pin (7) when the piston rod (19) is at rest.

4. Positioning device as claimed in Claim 1, characterized in that the lifting cylinder (15), via a magnetic valve (13), is connected to a pressure line through which compressed air (18) is supplied to the lifting cylinder (15) when the magnetic valve is excited, said compressed air causing an extension of the piston rod (19) in the direction of the printing form (1).

5. Positioning device as claimed in Claim 4, characterized in that the magnetic valve (13) is connected to a throttle-type sound absorber (14) through which the compressed air (18) is adjustably discharged when the magnetic valve (13) is deenergized.

6. Positioning device as claimed in Claim 1, characterized in that the mounting plate (16) carries an adjustable setting rail (12), on which a microswitch (11) is provided, the lug (35) of which protrudes in the path of motion of the ring (20) of the pressure member (10).

7. Positioning device as claimed in Claim 6, characterized in that the microswitch (11) excites a magnetic valve (36) by which compressed air is supplied to a vacuum suction head (37) connected to the exposure suction table (2), in order to suck on the printing plate (1).

8. Positioning device as claimed in Claim 1, characterized in that the slide member (5) is guided in a slotted guide hole (33) of the exposure suction table (2) and can be pivoted about a pin (34) arranged on a pressure member (28).

9. Positioning device as claimed in Claim 8, characterized in that on the underside of the exposure suction table (2) a support (24) is provided, in which a lifting cylinder (23) is displaceably arranged, on the piston rod (25) of which the pressure member (28) is seated, in the interior of which a compression spring (29) is located.

10. Positioning device as claimed in Claim 9, characterized in that the piston rod (25) is equipped with a pin (30) guided in a slotted hole (31) of the pressure member (28), and that the front surface of the piston rod (25) rests against the compression spring (29).

11. Positioning device as claimed in Claim 9, characterized in that the lifting cylinder (23) is connected with a magnetic valve (21), in the air inlet or outlet line of which an air strangler (32) is arranged, by means of which the speed at which the piston rod is moved, can be controlled.

12. Positioning device as claimed in Claim 11, characterized in that a throttle-type sound absorber (14) is connected to the magnetic valve (21), compressed air (22) being controllably discharged from this throttle-type sound absorber when the magnetic valve (21) is deenergized.

13. Positioning device as claimed in Claim 9, characterized in that on the underside of the exposure suction table (2) a stop plate (26) is installed which protrudes into the slotted guide hole (33) of the exposure suction table (2).

14. Positioning device as claimed in Claim 13, characterized in that the stop plate (26) has an angular shape and the slide member (5) is pivoted obliquely downwardly about the pin (34) by said stop plate (26) when the piston rod (25) is retracted.

15. Positioning device as claimed in Claim 14, characterized in that the slide member (5) has an inclined front surface which rests about 1 to 2 mm below the surface of the exposure suction table (2) when the slide member (5) is pivoted down.

16. Positioning device as claimed in Claim 14, characterized in that a leg spring (27) is arranged on the pressure member (28) and engages the slide member (5), in a way such that the latter is erected as soon as it is removed from the stop plate (26).

17. Positioning device as claimed in Claim 16, characterized in that the leg spring (27) is tripartite, one of its legs (27') engaging a groove (39) on the upperside of the pressure member (28), and the two other legs (27'', 27''') embracing legs (40) of a forked member (41) and engaging grooves provided near the edges of the legs (40).

**Revendications**

1. Dispositif de positionnement utilisé dans un appareil d'exposition/développement pour des formes d'impression, qui sont entraînées au moyen d'un dispositif de transport à rouleaux sur une table d'exposition comportant un dispositif formé d'un élément de pression et d'au moins une tige de butée pour le positionnement latéral, et un dispositif formé par un élément de pression et une butée pour le positionnement longitudinal de la forme d'impression individuelle, caractérisé en ce que l'élément de pression (10), actionné pneumatiquement et servant à réaliser le positionnement latéral et constitué par une tige cylindrique creuse (6) et un anneau (20), est supporté par une tige de piston (19) d'un vérin de levage (15), qui peut être chargé par de l'air comprimé et est réglable dans un support (17) fixé sur une plaque de montage (16), que les tiges de butée (4, 4') situées à l'opposé de l'élément de pression (10) sur la table d'exposition (2) peuvent être ajustées et que l'élément de pression utilisé pour le positionnement longitudinal est un poussoir (5) actionné simultanément de façon pneumatique par l'élément de pression (10) servant à réaliser le positionnement latéral.

2. Dispositif de positionnement selon la revendication 1, caractérisé en ce que l'élément de pression (10) est fixé sur la tige de piston (19) au moyen d'une goupille (7), qui est guidée dans une fente (8) de la tige (6) et traverse la tige de piston (19).

3. Dispositif de positionnement selon la revendication 1, caractérisé en ce qu'à l'intérieur de la tige (6) se trouve disposé un ressort de pression (9), qui repousse l'élément de pression (10) dans la position de repos de la tige de piston (19) contre la goupille (7).

4. Dispositif de positionnement selon la revendication 1, caractérisé en ce que le vérin de levage (15) est relié par l'intermédiaire d'une soupape électromagnétique (13) à une canalisation de pression qui, lorsque la soupape électromagnétique est excitée, charge le vérin de levage (15) avec de l'air comprimé (18), qui fait ressortir la tige de piston (19) en direction de la forme d'impression (1).

5. Dispositif de positionnement selon la revendication 4, caractérisé en ce que la soupape électromagnétique (13) est reliée à un amortisseur acoustique à papillon d'étranglement (14), que l'air comprimé (18) traverse en sortant, d'une manière réglable, lorsque la soupape électromagnétique (13) est désexcitée.

6. Dispositif de positionnement selon la revendication 1, caractérisé en ce que sur la plaque de montage (16) se trouve installé un rail ajustable de réglage (12) sur lequel est disposé un micro-interrupteur (11), dont la languette de commutation (35) pénètre dans la voie de déplacement de l'anneau (20) de l'élément de pression (10).

7. Dispositif de positionnement selon la revendication 6, caractérisé en ce que le micro-interrupteur (11) excite une soupape électromagnétique (36) qui charge une tête d'aspiration à dépression (37), reliée à la table aspirante d'exposition (2), avec de l'air comprimé afin de retenir par aspiration la plaque d'impression (1).

8. Dispositif de positionnement selon la revendication 1, caractérisé en ce que le poussoir (5) est guidé dans un guide (33) en forme de trou longitudinal de la table aspirante d'exposition (2) et est monté de manière à pouvoir pivoter autour d'un pivot (34) situé sur un élément de pression (28).

9. Dispositif de positionnement selon la revendication 8, caractérisé en ce que sur la face inférieure de la table aspirante d'exposition (2) se trouve installé un support (24), dans lequel peut se déplacer un vérin de levage (23), sur la tige de piston (25) duquel repose l'élément de pression (28), à l'intérieur duquel se trouve disposé un ressort de pression (29).

10. Dispositif de positionnement selon la revendication 9, caractérisé en ce que la tige de piston (25) est équipée d'un téton (30) qui est guidé dans un trou allongé (31) de l'élément de pression (28), et que la surface frontale de la tige de piston (25) s'applique contre le ressort de pression (29).

11. Dispositif de positionnement selon la revendication 9, caractérisé par le fait que le vérin de levage (23) est relié à une soupape électromagnétique (21), dans la canalisation d'alimentation ou de départ de laquelle se trouve installé un volet (32) d'étranglement de l'air, au moyen duquel la vitesse de déplacement de la tige de piston est réglable.

12. Dispositif de positionnement selon la revendication 11, caractérisé en ce qu'à la soupape électromagnétique (21) est raccordé un amortisseur acoustique à étranglement (14), que l'air comprimé (22) traverse, d'une manière réglable, lorsque la soupape électromagnétique (21) est désexcitée.

13. Dispositif de positionnement selon la revendication 9, caractérisé en ce que sur la face inférieure de la table aspirante d'exposition (2) se trouve disposée une tôle de butée (26) qui pénètre dans le guide (33) en forme d'ouverture allongée de la table aspirante d'exposition (2).

14. Dispositif de positionnement selon la revendication 13, caractérisé en ce que la tôle de butée (26) est coudée et fait pivoter obliquement vers le bas le poussoir (5) autour du pivot (34), lorsque la tige de piston (25) du vérin de levage (23) se rétracte.

15. Dispositif de positionnement selon la revendication 14, caractérisé en ce que la surface frontale du poussoir (5) est biseautée et est située, lorsque le poussoir est dans l'état pivoté, à 1 à 2 mm au-dessous de la surface de la table aspirante d'exposition (2).

16. Dispositif de positionnement selon la revendication 14, caractérisé en ce qu'un ressort à branches (27) est monté sur l'élément de compression (28) et est accroché au poussoir (5) de telle sorte qu'il redresse ce dernier de telle manière qu'il est séparé de la tôle de butée (26).

17. Dispositif de positionnement selon la revendication 16, caractérisé en ce que le ressort à branches (27) comporte trois branches, parmi lesquelles une branche (27') pénètre dans une rainure (39) ménagée dans la face supérieure de l'élément de compression (28), tandis que les deux autres branches (27", 27''') enserrent des branches (40) d'un élément en forme de fourche (41) et s'engagent dans des rainures proches des extrémités de ces branches.

Fig. 1

Fig. 2

Fig. 3

# Fig. 4